# EUROPÄISCHE PATENTANMELDUNG

(11) **EP 0 774 532 A2**
(43) Veröffentlichungstag der Anmeldung: **21.05.1997**
(21) Anmeldenummer: 96203081.3
(22) Anmeldetag: 05.11.1996
(51) Int. Cl.: C23C 16/26, C23C 16/04, C23C 16/56, G03F 1/14

(54) **Verfahren zur Herstellung einer Diamantschicht mit homogenisiertem Schichtdickenprofil und daraus hergestellte Diamantfenster und -membranen**

(30) Priorität: 14.11.1995 DE 19542366
(71) Anmelder: Philips Patentverwaltung GmbH, 22335 Hamburg (DE); PHILIPS ELECTRONICS N.V., 5621 BA Eindhoven (NL)
(72) Erfinder: Bachmann, Peter Klaus, Dr., 22335 Hamburg (DE); Wiechert, Detlef Uwe, 22335 Hamburg (DE); Kanetkar, Subhash, Dr., 22335 Hamburg (DE)
(74) Vertreter: Schmalz, Günther

(57) **Zusammenfassung**

Verfahren zur Herstellung einer Diamantschicht mit homogenisiertem Schichtdickenprofil, bei dem eine aus der Gasphase auf einem Substrat nach einem an sich bekannten Verfahren abgeschiedene Diamantschicht mit ungleichmäßigem Schichtdickenprofil an den Stellen großer Schichtdicke mit einer Maske abgedeckt wird und dann in einem zweiten Verfahrensschritt nur noch die nicht abgedeckten Schichtbereiche durch weitere Ablagerungen von Diamanten verstärkt werden, sowie Diamantfenster und Diamantmembranen, die ein nach dem erfindungsgemäßen Verfahren herstellbares Schichtdickenprofil aufweisen.

## Beschreibung

Die Erfindung betrifft ein Verfahren zur Herstellung einer Diamantschicht mit homogenisiertem Schichtdickenprofil, die für Diamantfenster und Diamantmembranen benötigt wird.

Es sind bereits verschiedene Verfahren bekannt, mit denen durch Abscheidung von Kohlenstoff aus der Gasphase auf einem Substrat Diamantschichten erzeugt werden können. Eine Übersicht über diese als CVD (= chemical vapour deposition) bezeichnenden Verfahren findet sich in dem Aufsatz "Diamant aus heißen Gasen" von P. K. Bachmann und U. Linz in der Zeitschrift "Spektrum der Wissenschaft", Ausgabe 9/1992, September 1992. In dieser Veröffentlichung ist auch beschrieben, daß aus dem so hergestellten Schichtmaterial optisch durchlässige Diamantmembranen durch partielles Entfernen des Substratmaterials, z.B. des Siliziums, hergestellt werden können. Diese Membranen können als Maskenträger für die Röntgenlithographie oder für Vakuumfenster eingesetzt werden. Das wird bspw. in der Veröffentlichung "Properties of diamond membranes for x-ray lithography" von H. Windischmann und G. Epps in der Zeitschrift "Journal of Applied Physics", Vol. 68, Nr. 11, Seite 5665-5673 (1990) eingehend beschrieben. In dieser Literaturstelle wird auch darauf hingewiesen, daß mit dem am häufigsten angewendeten Mikrowellenplasma-CVD-Verfahren hergestellten Diamantschichten ein Schichtdickenprofil aufweisen. Die Dicke der Schicht ist im Zentrum der Abscheidung am höchsten und fällt zum Rand des Substrats hin in Form einer Gauß- oder Besselfunktion monoton ab. Dieser Schichtdicken-Verlauf führt natürlich zu einer unterschiedlichen Transmission der elektromagnetischen Strahlung durch die Diamantschicht. Dies ist insbesondere störend bei der Anwendung von Diamantfenstern oder Diamantmembranen für lithographische Zwecke. Wünschenswert wäre eine gleichmäßige und hundertprozentige Transmission der elektromagnetischen Strahlung über den gesamten Radius. Das erfordert jedoch einen weitgehend homogenen Schichtdickenverlauf.

Verwendet man Diamantmembranen, die nach dem Stand der Technik durch das Mikrowellenplasma-CVD-Verfahren hergestellt wurden als Diamantfenster, die Zonen unterschiedlichen Drucks voneinander trennen (z.B. Vakuumfenster bildgebender Instrumente), so ist der Rand des Fensters die dünnste Stelle der Diamantmembran und bestimmt damit die Berstfestigkeit des Fensters. Der Einsatzbereich des Diamantfensters wird damit drastisch eingeschränkt.

Es stellte sich deshalb die Aufgabe, ein Verfahren zur Herstellung von Diamantfenstern mit homogenisiertem Schichtdickenprofil zu entwickeln, um eine weitgehend gleichmäßige Transmission für elektromagnetische Strahlungen über den ganzen Radiusbereich verbunden mit einer erhöhten Berstfestigkeit des Diamantfensters unter Verwendung der bisher für ihre Herstellung verwendeten Reaktoren zu erzielen.

Gelöst wird diese Aufgabe durch ein Verfahren zur Herstellung einer Diamantschicht mit homogenisiertem Schichtdickenprofil, bei dem eine aus der Gasphase auf einem Substrat nach an sich bekannten Verfahren abgeschiedene Diamantschicht mit ungleichmäßigem Schichtdickenprofil an den Stellen großer Schichtdicke mit einer Maske abgedeckt wird und dann in einem zweiten Verfahrensschritt nur noch die nichtabgedeckten Schichtbereiche durch weitere Ablagerungen von Diamantkristallen verstärkt werden.

Bei dem Mikrowellenplasma-CVD-Verfahren bilden sich die stärksten Ablagerungen regelmäßig auf der Mitte des Substrats. In diesem Fall wird erfindungsgemäß das Zentrum der zunächst abgeschiedenen Diamantschicht mit einer Maske abgedeckt und dann in der zweiten Verfahrensstufe nur noch die nicht abgedeckten Randbereiche der Diamantschicht durch weitere Ablagerungen von Diamantkristallen verstärkt.

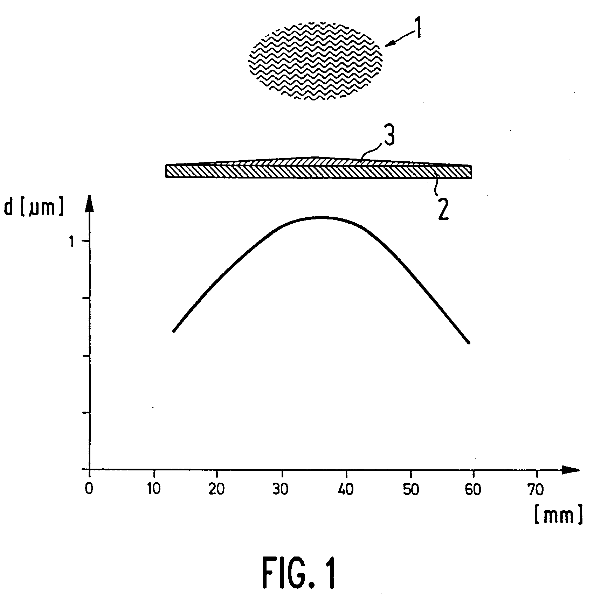

Der Verlauf des erfindungsgemäßen Beschichtungsverfahrens wird durch die Fig. 1 bis 3 verdeutlicht.

Fig. 1 zeigt, daß nach dem ersten Beschichtungsschritt des erfindungsgemäßen Verfahrens sich durch die ballförmige Mikrowellengasentladung (Plasma) 1 auf dem Substrat 2, das vorzugsweise eine Siliziumscheibe ist, eine Diamantschicht 3 gebildet hat. Das Diagramm zeigt, daß nach dem ersten Beschichtungsschritt gebildete Schichtdickenprofil.

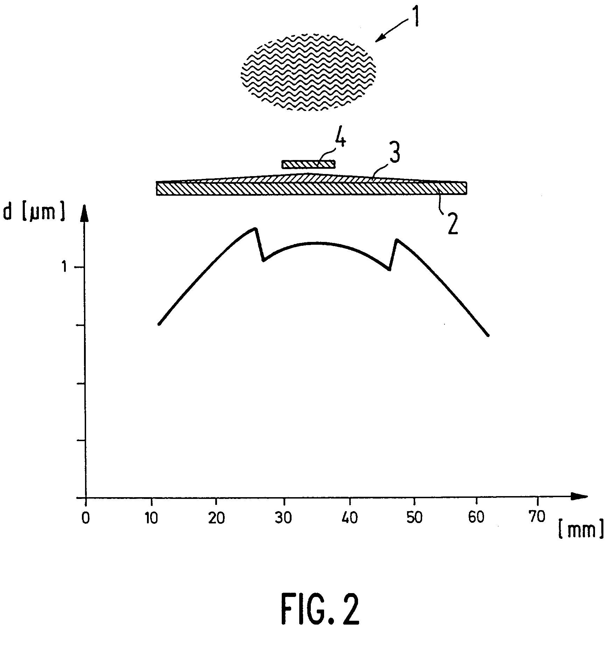

Fig. 2 zeigt, wie in einem zweiten Beschichtungsschritt ein Teil der bereits auf dem Substrat abgeschiedenen Diamantschicht 3 mit einer Maske 4 abgedeckt wird, so daß die Diamantschicht nur noch auf der nicht abgedeckten Oberfläche weiterwachsen kann. Das Diagramm zeigt das Schichtdickenprofil nach dem zweiten Beschichtungsschritt. Dabei entsteht an der Kante der Maske eine meßbare Stufe im Schichtdickenprofil. Die Höhe dieser Stufe hängt ab vom Verlauf des Schichtdickenprofils nach der ersten Beschichtung, vom Durchmesser der Maske, von der Dauer der nachfolgenden Beschichtung und vom Verlauf des Schichtdickenprofils in der Nachfolgebehandlung. Die Gesamthöhe dieser Stufe ist für das erfindungsgemäße Verfahren charakteristisch und am fertigen Produkt meßbar. Sie tritt in annähernd gleicher Höhe spiegelsymmetrisch um eine gemeinsame Achse im Schichtdickenprofil zweimal auf. Die Gesamthöhe einer solchen Stufe soll erfindungsgemäß mindestens 0,005 µm betragen.

Wenn es erforderlich ist, eine weitere zusätzliche Randverstärkung der Diamantschicht zu erzeugen, kann das beschriebene Verfahren mit verschieden großen Masken mehrmals wiederholt werden. Die Beschichtungszeiten sind dabei so zu bemessen, daß die gewünschte Schichtverstärkung erreicht wird.

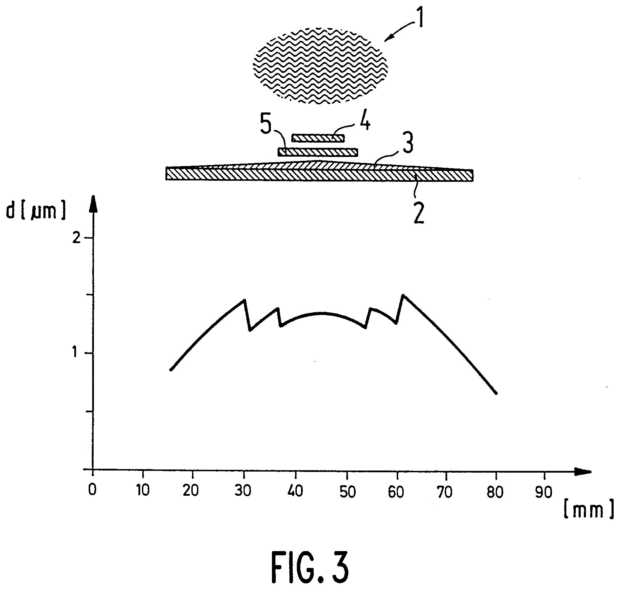

Fig. 3 zeigt, wie durch Anwendung einer ersten Maske 4 und einer zweiten Maske 5 ein Schichtdickenprofil erzeugt wird, das nach dem dritten Beschichtungsschritt aus einer Grundbeschichtung und zwei Folgebeschichtungen besteht. Zwei Paare von annähernd zentrosymmetrischen Schichtstufen sind erkennbar. Mit solchen Mehrfachbeschichtungen ist es möglich, den Außenbereich von Membranen für Vakuumanwendungen aufzudicken und so deren Berstfestigkeit zu verbessern, ohne die Membrandicke im Zentrum des Diamantfensters zu verändern.

Für das erfindungsgemäße Verfahren können z.B. Substrate aus Silizium, Molybdän oder Quarz eingesetzt werden, es ist jedoch nicht auf diese Materialien beschränkt.

Das erfindungsgemäße Verfahren hat den großen Vorteil, daß unter Verwendung von bereits zur Verfügung stehenden Mikrowellenplasma-CVD-Beschichtungsanlagen Diamantmembranen hergestellt werden können, deren Transparenz für elektromagnetische Strahlungen, insbesondere für UV und Röntgenstrahlung jeder Art einem gewünschten Verlauf über den Radius weitgehend angepaßt werden kann. Membranen, die als Vakuumfenster eingesetzt werden sollen, können bezüglich der geforderten mechanischen und der Transmissionseigenschaften optimiert werden. Ein weiterer Vorteil besteht darin, daß mittels des erfindungsgemäßen Verfahrens ausgewählte Bereiche eines durch die vorhandene Beschichtungsapparatur hergestellten Schichtdickenprofils relativ zueinander angehoben oder abgesenkt werden können, wie es der jeweilige Anwendungszweck erfordert.

Die erfindungsgemäß hergestellte Diamantfenster finden nicht nur Anwendung als Fenster für elektromagnetische Strahlung jedweder Art (Röntgenfenster, UV- oder IR-Fenster, Mikrowellenfenster) sondern auch als gering absorbierende Träger von hochabsorbierenden Strukturen (z.B. Metallmasken) in den verschiedensten Lithographie-Prozessen (Lithographie-Maskenträger) der Halbleiter- und Mikrostruktur-Technik (Röntgenlithographie, Litho-graphie-Galvanik-Abformung) (= LIGA).

### Ausführungsbeispiel

In einem kommerziell erhältlichen Mikrowellenplasma-CVD-Reaktor, der zur Abscheidung von Diamantschichten aus der Gasphase geeignet ist, (z.B. Fa. ASTeX, Applied Science and Technology, Woburn MA, Modell HPMS) wird bei einer Mikrowellenleistung von 800 Watt und bei einem Druck von 16 torr in einem Gasgemisch aus 4 Standardkubikzentimeter/Minute (sccm) Acetondampf und 496.2 sccm Wasserstoffgas eine ballförmige Gasentladung gezündet und Diamant auf der Oberfläche eines 10 cm Durchmesser großen Siliziumsubstrates abgeschieden (ähnlich Figur 1). Nach 5 Stunden Beschichtungszeit wird die Beschichtung unterbrochen und auf der Mitte des bereits beschichteten Siliziumsubstrates eine 0,5 mm dicke zweite Siliziumscheibe mit 2 cm Durchmesser angebracht. Danach wird die Beschichtung unter den bereits weiter oben genannten Bedingungen für weitere 30 Minuten wieder aufgenommen. Nach Abschluß des zweiten Beschichtungsschrittes ergibt sich Dickenverlauf der Diamantschicht ähnlich der in Fig. 2 gezeigten Form. Bei einem vorgegebenen Film-Nutzdurchmesser von 4 cm wird bei einer mittleren Schichtdicke von 1,2 µm eine Schwankungsbreite von ± 0,1 µm (≈ ±8%) erzielt. Ohne die Anwendung des erfindungsgemäßen Verfahrens ergibt sich unter den gleichen Beschichtungsbedingungen eine Variation von ± 0,18 µm (≈ ±15%).

## Patentansprüche

1. Verfahren zur Herstellung einer Diamantschicht mit homogenisiertem Schichtdickenprofil,
dadurch gekennzeichnet,
daß eine aus der Gasphase auf einem Substrat nach einem an sich bekannten Verfahren abgeschiedene Diamantschicht mit ungleichmäßigem Schichtdickenprofil an den Stellen großer Schichtdicke mit einer Maske abgedeckt wird und dann in einem zweiten Verfahrensschritt nur noch die nicht abgedeckten Schichtbereiche durch weitere Ablagerungen von Diamantkristallen verstärkt werden.

2. Verfahren nach Anspruch 1,
dadurch gekernzeichnet,
daß das Zentrum der zunächst abgeschiedenen Diamantschicht mit einer Maske abgedeckt und in der zweiten Verfahrensstufe nur die nicht abgedeckten Randbereiche der Diamantschicht durch weitere Ablagerungen von Diamantkristallen verstärkt werden.

3. Verfahren nach Anspruch 1,
dadurch gekernzeichnet,
daß die zweite Verfahrensstufe mit verschieden großen Masken mehrmals wiederholt wird.

4. Verfahren nach einem der vorstehenden Ansprüche,
dadurch gekennzeichnet,
daß als Substrat eine Siliziumplatte verwendet wird.

5. Verfahren nach Anspruch 1,
dadurch gekennzeichnet,
daß eine Maske aus Silizium eingesetzt wird.

6. Diamantfenster mit homogenisiertem Schichtdickenprofil,
dadurch gekennzeichnet,
daß es nach einem Verfahren der vorstehenden Ansprüche erhältlich ist.
